# EUROPEAN PATENT SPECIFICATION

(11) **EP 2 878 964 B1**
(45) Date of publication and mention of the grant of the patent: **06.07.2016**
(21) Application number: 13195304.4
(22) Date of filing: 02.12.2013
(51) Int. Cl.: G01R 31/26, G01R 25/00

(54) **Detecting shorted diodes**
Detektion kurzgeschlossener Dioden
Détection de diodes court-circuitées

(43) Date of publication of application: 03.06.2015
(73) Proprietor: ABB Technology AG, 8050 Zürich (CH)
(72) Inventor: Reist, Samuel, 8953 Dietikon (CH); Vetterli, Manuel, 4053 Basel (CH); Luescher, Matthias, 5728 Gontenschwil (CH); Rauchenstein, Juerg, 8853 Lachen (CH)
(74) Representative: ABB Patent Attorneys

(56) References cited:
- US-A1- 2011 216 449
- IORGULESCU MARIANA: "Study of three-phase bridge rectifier diagnosis based on output voltage and current analysis", 2013 8TH INTERNATIONAL SYMPOSIUM ON ADVANCED TOPICS IN ELECTRICAL ENGINEERING (ATEE), IEEE, 23 May 2013 (2013-05-23), pages 1-6, XP032483601, DOI: 10.1109/ATEE.2013.6563524 ISBN: 978-1-4673-5979-5 [retrieved on 2013-07-18]

## Description

### FIELD OF THE INVENTION

The invention relates to a method and a controller unit for detecting a shorted diode in a bridge rectifier, as well as to a bridge rectifier system.

### BACKGROUND OF THE INVENTION

Usually, three-phase bridge rectifiers or diode bridges comprise three series-connected pairs of diodes connected in parallel, which are interconnecting a three-phase AC voltage source with a DC load.

A normally functioning diode usually has a very low resistance in one (conducting) direction of current flow and a very high resistance in the other (blocking) direction. As any electronic components, diodes are subjected to wear and sometimes may be become faulty. A common fault is a so-called shorted diode, in which the very high resistance in blocking direction degrades and the diode conducts in both directions.

Since a shorted diode fault may lead to very high currents in the bridge rectifier and the connected equipment, after a detected shorted diode fault, the input current and/or the output current of the bridge rectifier may have to be shut down very fast making a reliable detection of such a fault very important.

For example, in US 2011/0216449 A1, the voltage across a pair of diodes is measured to determine a ratio between the individual diode voltages. This ratio is then analyzed, to determine whether one of the diodes has a fault.

IORGULESCU MARIANA: "Study of three-phase bridge rectifier diagnosis based on output voltage and current analysis", 2013 8TH INTERNATIONAL SYMPOSIUM ON ADVANCED TOPICS IN ELECTRICAL ENGINEERING (ATEE), IEEE, 23 May 2013 (2013-05-23), pages 1-6 addresses the issue of detecting and diagnosing three-phase bridge rectifier faults caused by diodes faults or phase failure.

### DESCRIPTION OF THE INVENTION

Objectives of the inventions are to detect a diode fault fast, reliable and in a simple way.

These objectives are achieved by the subject-matter of the independent claims. Further exemplary embodiments are evident from the dependent claims and the following description.

A first aspect of the invention relates to a method for detecting a shorted diode in a bridge rectifier or diode bridge, which, in particular may be a medium voltage bridge rectifier. As already mentioned, a shorted diode may be a diode that is conducting in both directions.

A bridge rectifier may comprise two series-connected diodes for each phase of the bridge rectifier. A phase input may be provided between each pair of series-connected diodes. The pairs of series-connected diodes may be connected in parallel to provide a DC output of the bridge rectifier. For example, the bridge rectifier may be of 6-pulse type (with three pairs of diodes) and any combination thereof (i.e. of 12-pulse type, 24-pulse type, 36-pulse type, etc.).

According to claim 1 of the invention, the method comprises the steps of: determining a phase-to-phase voltage between two phase inputs of the bridge rectifier, wherein a phase input is provided between the two series-connected diodes of the respective phase; and indicating a shorted diode fault by determining whether the phase-to-phase voltage is zero for more than a commutation time of the bridge rectifier. It may be possible that all phase-to-phase voltages between the phase inputs are determined.

In normal operation (no fault), the phase-to-phase voltages at the phase inputs are remaining close to zero voltage (for example below a certain threshold) when the corresponding diodes are commutating. For example, when a first phase voltage is becoming higher than a second phase voltage, the corresponding first diode is yet conducting, while the corresponding second diode starts to conduct. During this time, the rectifier is shorting the phases. Phase inductors connected to the phase inputs (such as transformer windings) will maintain a short-circuit current for a finite commutation time. This commutation time is specific for a given rectifier system and usually does not exceed a certain worst case value in normal operation.

In case of a diode fault (shorting), the bridge rectifier also generates a short on input phases. However, in this situation, the short persists longer than the commutation time. The corresponding phase-to-phase voltage is close to zero for a time that is longer than the worst case commutation time for the given rectifier system. The method uses this fact to detect a diode fault. In particular, in the case a zero or nearly zero phase-to-phase voltage is detected or determined for a time longer than the worst case commutation time, a diode fault may be detected and/or a diode fault output signal may be generated.

According to an embodiment of the invention, the phase-to-phase voltage is determined by the steps of: measuring a first phase voltage at a first phase input of the bridge rectifier; measuring a second phase voltage of a second phase input of the bridge rectifier; and calculating the phase-to-phase voltage as the difference between the first phase voltage and the second phase voltage. For example, the (for example three) phase voltages may be measured with respect to the same reference. The phase-to-phase voltages may be calculated from differences of these phase voltages.

According to an embodiment of the invention, it is determined, whether the phase-to-phase voltage is zero, when the absolute value of the phase-to-phase voltage is smaller than a predefined voltage threshold value. For example, in a medium voltage system, the magnitude of the phase voltages may range between zero and more than 1000 V (and therefore the phase-to-phase voltages may be more than 2000 V). In this case, a phase-to-phase voltage below 100 V, such as 80 V may indicate a (nearly) zero voltage. In general, the voltage threshold value may be smaller than about 10 % of a maximal phase voltage at a phase input of the bridge rectifier.

According to an embodiment of the invention, it is determined, whether the phase-to-phase voltage is zero for more than a commutation time of the bridge rectifier, when a time, during which the phase-to-phase voltage is zero, is longer than a predefined time threshold value (i.e. a worst case commutation time). For example, when the phase voltages have a frequency of 50 Hz or 60 Hz, the commutation time may be about 2 ms. In this case, the time threshold value may be about 3 ms. In general, the time threshold value may be smaller than 20 % of the period of an AC voltage at a phase input of the bridge rectifier.

According to an embodiment of the invention, the bridge rectifier has at least three phase inputs, and at least three phase-to-phase voltages are determined between the at least three phase inputs of the rectifier. As already said, the bridge rectifier may be a 12-pulse rectifier.

According to an embodiment of the invention, the method further comprises the steps of: determining, whether a circuit breaker connected to the phase inputs is open; and only indicating a shorted diode, when the circuit breaker is closed (i.e. not open). Additionally, the state of a circuit breaker may be detected to mask a fault signal when the circuit breaker is open. Otherwise, the vanishing voltages at the opening of the circuit breaker may be interpreted as diode fault.

Since in reaction to a diode fault, the outputs of the bridge rectifier may be shortcircuited, which may result in high energy losses and strong wear of the components of the rectifier system, the masking of not correctly detected diode faults may result in smaller losses and a longer lifetime of the system.

According to an embodiment of the invention, it is determined that the circuit breaker is open by determining that the absolute value of at least two or all phase-to-phase voltages is zero or smaller than a predefined threshold voltage. The state (such as opened or closed) of the circuit breaker may be determined based on the same voltage measurements, which are used for the diode fault determination.

A further aspect of the invention relates to a controller unit for a bridge rectifier, wherein the controller unit is adapted for executing the steps of the method as described in the above and in the following. The controller unit may be a part or a sub-module of a controller of the rectifier system. For example, the method may be implemented in hardware or in software executed in a processor of the controller unit.

According to an embodiment of the invention, the controller unit comprises an FPGA. It is also possible that the control method is implemented in an FPGA. For example, the control unit may comprise a voltage measurement board, which allows measuring the medium voltages at the phase input of the bridge rectifier and/or may comprise an FPGA board, which may process the measured values in order to detect a diode fault.

A further aspect of the invention relates to a bridge rectifier system, comprising a bridge rectifier with two series-connected diodes for each phase, providing a phase input between them, wherein the series-connected diodes for each phase are connected in parallel to a DC output of the bridge rectifier; and a controller unit as described in the above and in the following. In the case of a bridge rectifier with higher pulse order (12-pulse, 24-pulse, etc.), the method may be applied for each three-phase rectifier of the complete bridge rectifier individually. The diodes may be medium voltage diodes.

According to an embodiment of the invention, the bridge rectifier system further comprises a transformer interconnecting the phase inputs of the bridge rectifier with a voltage source. The controller unit may be adapted to measure a phase voltage at a phase input of the bridge rectifier between the transformer and the phase input. In general, the method also applies for rectifier systems that do not have a transformer but are directly connected to the power grid.

According to an embodiment of the invention, the bridge rectifier system further comprises a circuit breaker adapted for disconnecting a voltage source from the bridge rectifier. The circuit breaker may connect a power grid as voltage source to the transformer which is then feeding the bridge rectifier.

It has to be understood that features of the method as described in the above and in the following may be features of the controller unit and/or bridge rectifier system as described in the above and in the following, and vice versa.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a circuit diagram of a bridge rectifier system according to an embodiment of the invention.
Fig. 2 shows a flow diagram for a method for detecting a shorted diode according to an embodiment of the invention.
Fig. 3 shows a diagram with phase-to-phase voltages during normal operation of the system of Fig. 1.
Fig. 4 shows a diagram with phase-to-phase voltages during faulty operation of the system of Fig. 1.

The reference symbols used in the drawings and their meanings are listed in summary form in the list of reference symbols. In principle, identical parts are provided with the same reference symbols in the figures.

### DETAILED DESCRIPTION OF EXEMPLARY EMBODIMENTS

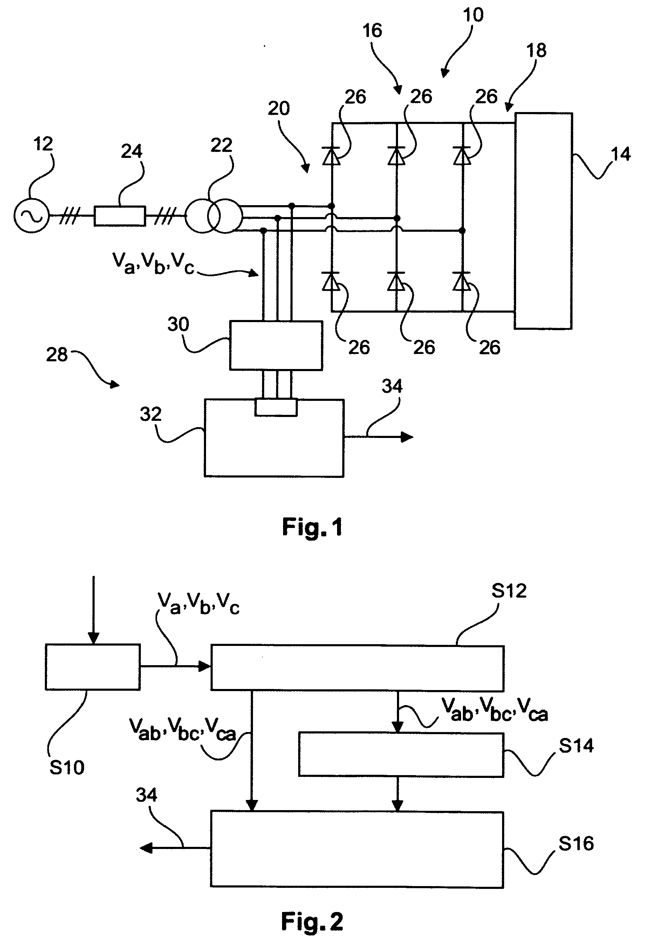

Fig. 1 shows a rectifier system 10 that connects a power source (power grid) 12 providing a multi-phase AC voltage with a DC load 14. The rectifier system 10 comprises a bridge rectifier 16 with a DC output 18 and three phase inputs 20 connected with a transformer 22 that is supplied from the power source 12 via a circuit breaker 24.

The bridge rectifier 16 comprises three pairs of diodes 26 that are connected in parallel with the DC output 18. The two diodes 26 of each pair of diodes 26 are connected in series and provide one of the AC phase inputs 20 between them. The shown bridge rectifier 16 is a 6-pulse rectifier. Corresponding 12-, 24- or 36-pulse rectifiers would have 6, 12, ... phase inputs and pairs of diodes.

To increase the voltage strength of the rectifier 16, each single diode 26 may be replaced by a series connection of two or more diodes (for example, a six pulse rectifier would then have four diodes per phase leg; 12 diodes in total).

A controller unit 28 of the rectifier system 10 comprises a voltage measurement board 30 that is adapted for measuring the phase voltages Vₐ, V_{b}, V_{c} at the phase inputs 20, and a further fault detection board 32 that is adapted for evaluating the measured phase voltages and for providing a fault indication signal 34, in the case a diode fault is detected.

For example, the fault detection board 32 may be based on an FPGA that receives the digitized measured phase voltage values and processes them as described with respect to Fig. 2.

Fig. 2 shows a flow diagram, for a method for detecting a shorted diode 26 of the rectifier 16 that may be performed by the controller unit 28.

In step S10, the phase voltages Vₐ, V_{b}, V_{c} are measured with respect to a common reference (such as the ground potential) and digitized by the voltage measurement board 30. The measured phase voltages Vₐ, V_{b}, V_{c} are then input to the fault detection board 32, which performs the following steps S12 to S16.

In step S12, the phase-to-phase voltages V_{ab}, V_{bc}, V_{ca} between the phase inputs 20 are calculated as the differences between the phase voltages Vₐ, V_{b}, V_{c}.

In step S14, it is determined, whether the circuit breaker 22 is open. The phase-to-phase voltages V_{ab}, V_{bc}, V_{ca} are compared to a voltage threshold value. In the case where the absolute value of the all three phase-to-phase voltages V_{ab}, V_{bc}, V_{ca} are smaller than the voltage threshold value, it is assumed that the circuit breaker is open.

In the case where it has been determined in step S14 that the circuit breaker is open, the fault detection board 32 determines in step S16, whether a phase-to-phase voltage V_{ab}, V_{bc}, V_{ca} is zero for more than a worst case commutation time of the bridge rectifier.

First, the phase-to-phase voltages V_{ab}, V_{bc}, V_{ca} are compared to a voltage threshold value (which may be the same or a different value as the one used in step S14) to determine if one of these voltages is zero, when the absolute value of the corresponding voltage is smaller than the voltage threshold value.

If one of the phase-to-phase voltages V_{ab}, V_{bc}, V_{ca} is considered to be zero, the time for which this voltage is zero is determined. For example, the steps of the method may be repeated regularly for every time step, and a counter for the respective phase-to-phase voltages V_{ab}, V_{bc}, V_{ca} may be incremented, in the case where the voltage is zero. The corresponding time then may be calculated as the duration of the time step times the counter.

If the time during which the phase-to-phase-voltage V_{ab}, V_{bc}, V_{ca} is zero is longer than a time threshold value (longer than a worst case commutation time), then it is assumed that a diode 26 has shorted and a corresponding fault signal 34 is output.

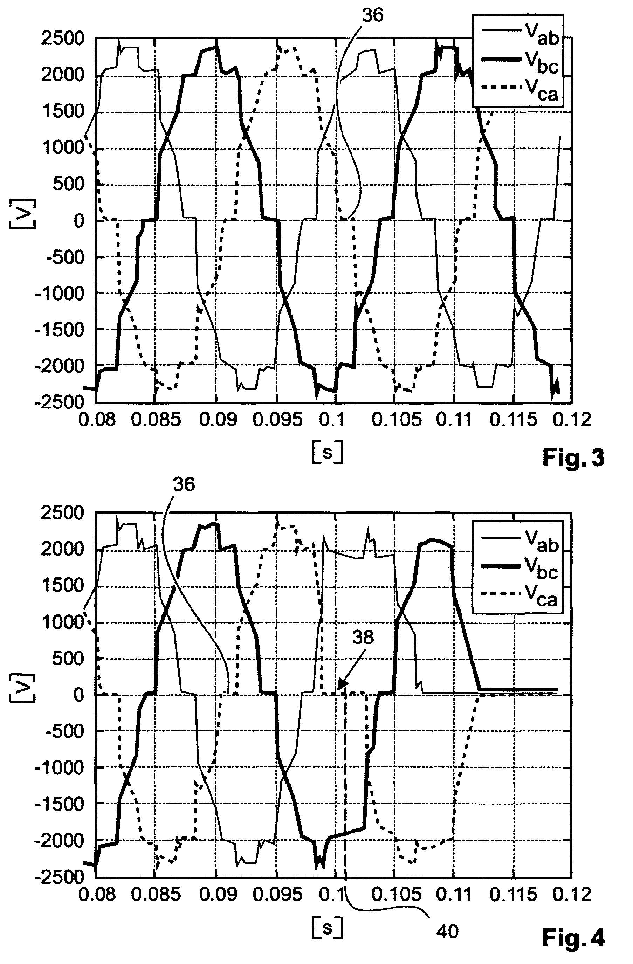

As an example, Fig. 3 shows a diagram with three phase-to-phase-voltages V_{ab}, V_{bc}, V_{ca} during a normal operation of the bridge rectifier 16. The commutation times 36 of the diodes 16 are always about 2 ms.

Fig. 4 shows a corresponding diagram, in which a diode shorting occurred at 0.1 s. The time 38, where the phase-to-phase voltage V_{ca} is nearly zero is much longer than the commutation time 36. Thus, already at time point 40 the method may indicate a diode fault.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: rectifier system
- 12: power source
- 14: load
- 16: bridge rectifier
- 18: DC output
- 20: AC phase input
- 22: transformer
- 24: circuit breaker
- 26: diode
- 28: controller unit
- Vₐ, V_{b}, V_{c}: phase voltage
- 30: voltage measurement board
- 32: fault detection board
- 34: fault indication signal
- Vab, Vbc, Vca: phase-to-phase voltage
- 36: commutation time
- 38: diode shorting time
- 40: fault indication time

## Claims

1. A method for detecting a shorted diode in a bridge rectifier (16) comprising two series-connected diodes (26) for each phase of the bridge rectifier, **characterised in that** the method comprises:
determining a phase-to-phase voltage (V_{ab}, V_{bc}, V_{ca}) between two phase inputs (20) of the bridge rectifier (16), wherein a phase input (20) is provided between the two series connected diodes (26) of the respective phase; and
indicating a shorted diode fault by determining whether the phase-to-phase voltage is zero for more than a commutation time (36) of the bridge rectifier (16).

2. The method of claim 1, wherein the phase-to-phase voltage is determined by:
measuring a first phase voltage (Vₐ, V_{b}, V_{c}) at a first phase input (20) of the bridge rectifier (16);
measuring a second phase voltage of a second phase input of the bridge rectifier; and
calculating the phase-to-phase voltage as the difference between the first phase voltage and the second phase voltage.

3. The method of claim 1 or 2, wherein it is determined, whether the phase-to-phase voltage is zero, when the phase-to-phase voltage is smaller than a predefined voltage threshold value.

4. The method of claim 3, wherein the voltage threshold value is smaller than 10 % of a maximal phase voltage at a phase input of the bridge rectifier.

5. The method of one of the preceding claims, wherein it is determined, whether the phase-to-phase voltage is zero for more than a commutation time (36) of the bridge rectifier by determining that a time, during which the phase-to-phase voltage is zero, is longer than a predefined time threshold value.

6. The method of claim 5,
wherein the time threshold value is smaller than 20 % of the period of an AC voltage at a phase input of the bridge rectifier.

7. The method of one of the preceding claims,
wherein the bridge rectifier (16) has at least three phase inputs (20), and at least three phase-to-phase voltages are determined between the at least three phase inputs of the rectifier.

8. The method of one of the preceding claims, further comprising:
determining, whether a circuit breaker (24) connected to the phase inputs (20) is open;
only indicating a shorted diode, when the circuit breaker (24) is closed.

9. The method of claim 8,
wherein it is determined that the circuit breaker (24) is open by determining that three phase-to-phase voltages are smaller than a predefined threshold voltage.

10. A controller unit (28) for a bridge rectifier (16), wherein the controller unit is adapted for executing the steps of the method of one of the claims 1 to 9.

11. The controller unit (28) of claim 10, comprising an FPGA.

12. A bridge rectifier system (10), comprising:
a bridge rectifier (16) with two series connected diodes (26) for each phase providing a phase input (20) between them, wherein the series connected diodes for each phase are connected in parallel to an DC output (18) of the bridge rectifier; and
a controller unit (28) according to claims 10 or 11.

13. The bridge rectifier system (10) of claim 12, further comprising:
a transformer (22) interconnecting the phase inputs (20) of the bridge rectifier with a voltage source;
wherein the controller unit (28) is adapted to measure a phase voltage at a phase input (20) of the bridge rectifier (16) between the transformer (22) and the phase input (20).

14. The bridge rectifier system (10) of claim 12 or 13, further comprising:
a circuit breaker (24) adapted for disconnecting a voltage source (12) from the bridge rectifier (16).

15. The bridge rectifier system (10) of one of claims 12 to 14,
wherein the diodes (26) are medium voltage diodes.

## Patentansprüche

1. Verfahren zur Detektion einer kurzgeschlossenen Diode in einem Brückengleichrichter (16), der zwei in Reihe geschaltete Dioden (26) für jede Phase des Brückengleichrichters aufweist, **dadurch gekennzeichnet, dass** das Verfahren Folgendes aufweist:
Bestimmen einer Außenleiterspannung (V_{ab}, V_{bc}, V_{ca}) zwischen zwei Phaseneingängen (20) des Brückengleichrichters (16), wobei ein Phaseneingang (20) zwischen den zwei in Reihe geschalteten Dioden (26) der entsprechenden Phase bereitgestellt wird; und
Angeben eines kurzgeschlossenen Diodenfehlers durch Bestimmen, ob die Außenleiterspannung für mehr als eine Umschaltzeit (36) des Brückengleichrichters (16) null ist.

2. Verfahren nach Anspruch 1, wobei die Außenleiterspannung durch Folgendes bestimmt wird:
Messen einer ersten Phasenspannung (Vₐ, V_{b}, V_{c}) an einem ersten Phaseneingang (20) des Brückengleichrichters (16);
Messen einer zweiten Phasenspannung eines zweiten Phaseneingangs des Brückengleichrichters; und
Berechnen der Außenleiterspannung als die Differenz zwischen der ersten Phasenspannung und der zweiten Phasenspannung.

3. Verfahren nach Anspruch 1 oder 2,
wobei bestimmt wird, ob die Außenleiterspannung null ist, wenn die Außenleiterspannung kleiner ist als ein vorbestimmter Spannungsschwellenwert.

4. Verfahren nach Anspruch 3,
wobei der Spannungsschwellenwert kleiner als 10% einer maximalen Phasenspannung an einem Phaseneingang des Brückengleichrichters ist.

5. Verfahren nach einem der vorhergehenden Ansprüche,
wobei durch Bestimmen, dass eine Zeit, während der die Außenleiterspannung null ist, länger ist als ein vorbestimmter Zeitschwellenwert, bestimmt wird, ob die Außenleiterspannung während mehr als einer Umschaltzeit (36) des Brückengleichrichters null ist.

6. Verfahren nach Anspruch 5,
wobei der Zeitschwellenwert kleiner als 20% der Periode einer Wechselstromspannung an einem Phaseneingang des Brückengleichrichters ist.

7. Verfahren nach einem der vorhergehenden Ansprüche,
wobei der Brückengleichrichter (16) mindestens drei Phaseneingänge (20) aufweist und mindestens drei Außenleiterspannungen zwischen den mindestens drei Phaseneingängen des Gleichrichters bestimmt werden.

8. Verfahren nach einem der vorhergehenden Ansprüche, das ferner Folgendes aufweist:
Bestimmen, ob ein Leistungsschalter (24), der mit den Phaseneingängen (20) verbunden ist, offen ist;
Angeben einer kurzgeschlossenen Diode, nur wenn der Leistungsschalter (24) geschlossen ist.

9. Verfahren nach Anspruch 8,
wobei durch Bestimmen, dass drei Außenleiterspannungen niedriger als eine vorbestimmte Schwellenspannung sind, bestimmt wird, dass der Leistungsschalter (24) offen ist.

10. Steuereinheit (28) für einen Brückengleichrichter (16), wobei die Steuereinheit zum Ausführen der Schritte des Verfahrens nach einem der Ansprüche 1 bis 9 angepasst ist.

11. Steuereinheit (28) nach Anspruch 10, die ein FPGA aufweist.

12. Brückengleichrichtersystem (10), das Folgendes aufweist:
einen Brückengleichrichter (16) mit zwei in Reihe geschalteten Dioden (26) für jede Phase, die einen Phaseneingang (20) dazwischen bereitstellen, wobei die in Reihe geschalteten Dioden für jede Phase parallel mit einem Gleichstromausgang (18) des Brückengleichrichters verbunden sind; und
eine Steuereinheit (28) nach Anspruch 10 oder 11.

13. Brückengleichrichtersystem (10) nach Anspruch 12, das ferner Folgendes aufweist:
einen Transformator (22), der die Phaseneingänge (20) des Brückengleichrichters und eine Spannungsquelle miteinander verbindet;
wobei die Steuereinheit (28) angepasst ist, um eine Phasenspannung an einem Phaseneingang (20) des Brückengleichrichters (16) zwischen dem Transformator (22) und dem Phaseneingang (20) zu messen.

14. Brückengleichrichtersystem (10) nach Anspruch 12 oder 13, das ferner Folgendes aufweist:
einen Leistungsschalter (24), der zum Trennen einer Spannungsquelle (12) von dem Brückengleichrichter (16) angepasst ist.

15. Brückengleichrichtersystem (10) nach einem der Ansprüche 12 bis 14,
wobei die Dioden (26) Mittelspannungsdioden sind.

## Revendications

1. Procédé de détection d'une diode court-circuitée dans un redresseur (16) en pont comportant deux diodes (26) reliées en série pour chaque phase du redresseur en pont, **caractérisé en ce que** le procédé comporte les étapes consistant à :
déterminer une tension composée (Vab, Vbc, Vca) entre deux entrées (20) de phases du redresseur (16) en pont, une entrée (20) de phase étant placée entre les deux diodes (26) reliées en série de la phase considérée ; et
indiquer un défaut de diode court-circuitée en déterminant si la tension composée est nulle pendant un temps supérieur à un temps (36) de commutation du redresseur (16) en pont.

2. Procédé selon la revendication 1, la tension composée étant déterminée en :
mesurant une première tension (Va, Vb, Vc) de phase à une première entrée (20) de phase du redresseur (16) en pont ;
mesurant une deuxième tension de phase d'une deuxième entrée de phase du redresseur en pont ; et
calculant la tension composée comme la différence entre la première tension de phase et la deuxième tension de phase.

3. Procédé selon la revendication 1 ou 2,
une détermination étant effectuée selon laquelle la tension composée est nulle ou non, lorsque la tension composée est inférieure à une valeur seuil prédéfinie de tension.

4. Procédé selon la revendication 3,
la valeur seuil de tension étant inférieure à 10% d'une tension maximale de phase à une entrée de phase du redresseur en pont.

5. Procédé selon l'une des revendications précédentes, une détermination étant effectuée selon laquelle la tension composée est nulle pendant un temps supérieur à un temps (36) de commutation du redresseur en pont ou non en déterminant qu'un temps pendant lequel la tension composée est nulle est supérieur à une valeur seuil prédéfinie de temps.

6. Procédé selon la revendication 5,
la valeur seuil de temps étant inférieure à 20% de la période d'une tension alternative à une entrée de phase du redresseur en pont.

7. Procédé selon l'une des revendications précédentes, le redresseur (16) en pont étant doté d'au moins trois entrées (20) de phases, et au moins trois tensions composées étant déterminées entre lesdites au moins trois entrées de phases du redresseur.

8. Procédé selon l'une des revendications précédentes, comportant en outre les étapes consistant à :
déterminer si un disjoncteur (24) relié aux entrées (20) de phases est ouvert ;
n'indiquer une diode court-circuitée que lorsque le disjoncteur (24) est fermé.

9. Procédé selon la revendication 8,
la détermination selon laquelle le disjoncteur (24) est ouvert ayant lieu en déterminant que trois tensions composées sont inférieures à une tension seuil prédéfinie.

10. Unité (28) de commande destinée à un redresseur (16) en pont, l'unité de commande étant prévue pour exécuter les étapes du procédé selon l'une des revendications 1 à 9.

11. Unité (28) de commande selon la revendication 10, comportant un FPGA.

12. Système (10) de redresseur en pont, comportant :
un redresseur (16) en pont doté de deux diodes (26) reliées en série pour chaque phase constituant une entrée (20) de phase entre elles, les diodes reliées en série pour chaque phase étant reliées en parallèle à une sortie (18) à courant continu du redresseur en pont ; et une unité (28) de commande selon les revendications 10 ou 11.

13. Système (10) de redresseur en pont selon la revendication 12, comportant en outre :
un transformateur (22) interconnectant les entrées (20) de phases du redresseur en pont avec une source de tension ;
l'unité (28) de commande étant prévue pour mesurer une tension de phase à une entrée (20) de phase du redresseur (16) en pont entre le transformateur (22) et l'entrée (20) de phase.

14. Système (10) de redresseur en pont selon la revendication 12 ou 13, comportant en outre :
un disjoncteur (24) prévu pour déconnecter une source de tension (12) du redresseur (16) en pont.

15. Système (10) de redresseur en pont selon l'une des revendications 12 à 14,
les diodes (26) étant des diodes à moyenne tension.
